# EUROPEAN PATENT SPECIFICATION

(11) **EP 2 372 753 B1**
(45) Date of publication and mention of the grant of the patent: **16.01.2013**
(21) Application number: 11172271.6
(22) Date of filing: 21.09.2001
(51) Int. Cl.: H01L 21/205, C23C 16/44, C09K 13/08, C23F 4/00, H01L 21/3213

(54) **Gas Compositions for Cleaning the Interiors of Reactors as Well as for Etching Films of Silicon-Containing Compounds**
Gaszusammensetzungen zum Reinigen des Reaktorinneren sowie zum Ätzen von Filmen aus siliciumhaltigen Verbindungen
Compositions gazeuses pour nettoyer lýintérieur de réacteurs et pour décaper des films de composés contenant du silicium

(30) Priority: 25.09.2000 JP 2000290893
(43) Date of publication of application: 05.10.2011
(62) Divisional of application: 01970182.0
(73) Proprietor: TOKYO ELECTRON LIMITED, Minato-ku Tokyo 107-0052 (JP); Renesas Electronics Corporation, Kanagawa (JP); Panasonic Corporation, Kadoma-shi Osaka 571-8501 (JP); Daikin Industries, Ltd., Osaka-shi, Osaka 530-8323 (JP); Canon Anelva Corporation, Kawasaki-shi Kanagawa 215-8550 (JP); Sanyo Electric Co., Ltd., Osaka 570-8677 (JP); Hitachi Kokusai Electric Inc., Tokyo 164-0003 (JP); Sony Corporation, Tokyo 141-8680 (JP); Kanto Denka Kogyo Co., Ltd., Chiyoda-ku, Tokyo 100-0005 (JP); National Institute of Advanced Industrial Science and Technology, Tokyo 100-8921 (JP)
(72) Inventor: Sekiya, Akira, Tsukuba-shi, Ibaraki 305-0841 (JP); Fukae, Katsuya, Gunma, Gunma 377-8513 (JP); Mitsui, Yuki, Chiyoda-ku, Tokyo 104-8405 (JP); Tomizawa, Ginjiro, Osaka 566-8585 (JP)
(74) Representative: Gregory, Robert John H.

(56) References cited:
- WO-A-99/67817
- JP-A- 4 026 116
- US-A- 4 536 252
- US-A- 5 376 234
- US-A- 5 445 712

## Description

### Field of the Invention

This invention relates to gas compositions comprising a fluorine-containing nitrogen compound, which compositions are useful for cleaning the interior of reactors such as chambers for CVD (chemical vapor deposition) processes or etch processes used for manufacturing semiconductor devices on substrates. The invention also relates to such gas compositions capable of efficiently etching films of silicon-containing compounds. Advantageously, the gas compositions have little or no tendency to generate an effluent gas stream containing noxious ingredients, such as CF₄, NF₃ and the like.

### Background of the Invention

WO 99/67817 discloses etching a silicon surface using a gas which comprises at least three reactive gases which include at least one fluorine-containing compound which does not contain silicon, at least one silicon-containing compound, and oxygen.

US 4,536,252 discloses laser-induced production of nitrosyl fluoride for etching of semiconductor surfaces.

To date, in processes for producing thin-film devices, such as for the production of semiconductors, thin films have been formed by known techniques such as CVD processes. In the formation of such a film, e. g. a thin film for semiconductor devices within a CVD chamber, though it is desirable to allow or permit a film-forming material to deposit preferentially over the target area or areas of the wafer substrate or substrates held in the CVD chamber, the film-forming material is also deposited, though wastefully, on the remaining surfaces exposed to the interior space of the CVD chamber, including, for example, the surfaces of inner walls of chamber, product-holding jigs, pipings, etc. Furthermore, during the deposition process, the material which has accumulated on surface areas other than the target area(s) can be accidentally separated therefrom. Consequently, the peeled-off material or particles thereof can often be carried to the target area where a film is being formed or to be formed, and can cause the film to become contaminated therewith. This would prevent the process operation from producing films of satisfactory quality, and thus would lead to decreased yield. Therefore, it is necessary to remove any undesirably deposited material from the chamber at appropriate intervals and clean the chamber. Removal of the obstructive deposits from the interior of CVD chambers has been carried out manually or chemically, by means of cleaning gases.

In the production of semiconductors and other electronic devices, it is also necessary to partially remove a layer or layers of various semiconductive materials deposited on a wafer substrate by means of an etchant, typically an etching gas, so as to leave a semiconductor circuit in a pre-determined pattern on the wafer substrate.

Some fundamental properties are generally required for the chamber cleaning gas and the etching gas which both act to remove the materials deposited in the chamber. The cleaning gas should be able to rapidly clean the interior of the CVD chamber, while the etching gas should be able to selectively and rapidly etch the selected area or areas of deposited film. Further properties commonly required for the cleaning and etching gases include, for example, that they do not generate noxious effluent gases and they are environmentally friendly.

Heretofore, a class of perfluorocompounds, such as CF₄, C₂F₆, SF₆, NF₃ and the like have been employed in large amounts in the processes for producing semiconductors and other electronic devices, as a gas for either removing the deposited materials or for etching the deposited films.

However, these conventional perfluorocompound gases are stable substances that can last for a long period of time in the atmosphere and it is difficult to treat a waste gas stream omitting the cleaning step or the etching step in which the above-mentioned conventional cleaning or etching gases are employed. The waste gas stream may contain a high level of the cleaning or etching gas ingredient(s) in an undecomposed or undegraded state and the treatment to reduce these to acceptable levels before discharging to the atmosphere is very expensive. These aforementioned problems have been presented by the conventional cleaning and etching gases. Furthermore, it is known that the conventional perfluorocompound gases have very high global warming potential (ITH; 100 years): when compared with carbon dioxide (CO₂), CF₄ exhibits a factor 6,500 times; C₂F₆ exhibits a factor 9,200 times; SF₆ exhibits a factor 23,900 times; and NF₃ exhibits a factor 8,000 times, respectively, that of CO₂. There is a concern that these substances could have a serious effect on the environment.

Under the circumstances, there has been a strong need for a substitute etching or cleaning gas that has a low global warming potential, one which exhibits excellent performance in cleaning deposits of silicon-containing compounds as well as excellent etching performance for the silicon-containing compound films.

Even if a gas itself as used in the cleaning or etching process has no or little effect on the environment, the gas could be subject to decomposition during the cleaning or etching process, at the same time generating noxious gases, such as CF₄ and NF₃, which last for a long period of time in the atmosphere. Therefore, it is desired to provide a substitute etching or cleaning gas that will not decompose to produce any noxious gas or gases having an adverse effect on the environment.

Thus, the inventors, having focused their efforts on research into the amelioration or elimination of the above-mentioned prior art problems, have now discovered that a particular kind of fluorine-containing nitrogen compound offers: improved ability to clean deposits comprising silicon-containing compound(s), while generating, during use in a cleaning process, an effluent gas stream containing no noxious compounds, such as CF₄, NF₃ or the like, that seriously contribute to global warming; also, improved ability to etch a thin film comprising silicon-containing compound(s), while generating, during use in an etching process, an effluent gas stream containing no noxious compounds, such as CF₄, NF₃ or the like, that seriously contribute to global warming.

The present invention has been developed and accomplished on the basis of the above finding.

Accordingly, an object of the invention is to provide a CVD chamber cleaning gas composition which has excellent performance in cleaning deposits comprising silicon-containing compound(s) and, thus, is useful for cleaning the interior of reactors such as chambers for CVD process used for manufacturing semiconductors, and other electronic devices or the like layered on wafer substrates, and which will generate, during use in a cleaning process, an effluent gas stream containing no noxious compounds, such as CF₄, NF₃ and the like, that seriously contribute to global warming.

A further object of the invention is to provide an etching gas composition which offers excellent performance in etching films comprising silicon-containing compound(s) for manufacturing semiconductors, and other electronic devices or the like layered on substrates, and which will generate, during use in an etching process, an effluent gas stream containing no noxious compounds, such as CF₄ or the like, that seriously contribute to global warming.

### Summary of the Invention

### CVD chamber cleaning gas compositions:

In accordance with the invention, there is provided an FNO-containing gas composition for cleaning the interior of CVD chambers, which consists of FNO in combination with O₂. Preferably, this gas composition for cleaning CVD chambers being 20-50 mol % of FNO per 100 mol % of the total quantity of the gas ingredients in the composition. Desirably, the content of O₂ in the gas composition ranges from 50 to 80 mol %.

The gas composition for cleaning CVD chambers may consist of an inert gas or gases in place of the O₂, wherein the content of FNO is desirably in the range of 55-95 mol % per 100 mol % of the total quantity of the gas ingredients in the composition. Desirably, the content of said inert gas or gases is in the range of 5-45 mol %.

Alternatively, the gas composition for cleaning CVD chambers may consist of an inert gas or gases in addition to the FNO and O₂, wherein the content of FNO is desirably in the range of 20-90 mol % per 100 mol % of the total quantity of the gas ingredients in the composition.

Suitable examples of inert gases which may be used in the above-mentioned CVD chamber cleaning gas composition include N₂, He, Ne, Ar, Kr, Xe and Rn.

### Etching gas compositions:

According to a further aspect of the invention, there is further provided an etching gas composition suitable for etching films of silicon-containing compounds, which consists of FNO and O₂ and wherein the content of FNO is in the range of 20-50 mol % per 100 mol % of the total quantity of the gas ingredients in the composition. The content of the O₂ is desirably in the range of 50-80 mol %.

The etching gas composition may have an inert gas or gases in place of the O₂, wherein the content of FNO is desirably in the range of 55-95 mol % per 100 mol % of the total quantity of the gas ingredients in the composition. Desirably, the content of said inert gas or gases is in the range of 5-45 mol %.

Alternatively, the etching gas composition may have an inert gas or gases in addition to the FNO and O₂, wherein the content of FNO is desirably in the range of 20-90 mol % per 100 mol % of the total quantity of the gas ingredients in the composition.

Suitable examples of the inert gases which may be used in the above-mentioned etching gas compositions include N₂, He, Ne, Ar, Kr, Xe and Rn.

Typical examples of the silicon-containing compounds which may be etched by the above etching gas compositions include: (1) compounds consisting essentially of silicon; (2) compounds consisting essentially of silicon and at least one of oxygen, nitrogen, fluorine and carbon; and (3) compounds comprising high melting point metal silicides.

### Embodiments of the Invention

The gas compositions for removing deposits comprising silicon-containing compounds in CVD chambers and for etching film layers comprising silicon-containing compounds in accordance with the invention are listed in the claims. These will be described in more detail.

### CVD CHAMBER CLEANING GAS COMPOSITIONS:

The CVD chamber cleaning gas compositions according to the invention are listed in the claims. These will be explained below.

### FNO-containing gas mixtures (cleaning gas compositions)

The chamber cleaning gas compositions of the invention are characterized by inclusion of FNO in combination with O₂ and/or one or more inert gases.

In the case where the chamber cleaning gas composition of the invention consists of FNO and O₂, the content of FNO is desirably in the range of 20-50 mol %, and preferably 30-45 mol % per 100 mol % of the total quantity of the ingredients in the composition. The content of O₂ is desirably in the range of 50-80 mol %, and preferably 55-70 mol %.

Further, in the case where the chamber cleaning gas composition of the invention consists of FNO and an inert gas or gases, the content of FNO is desirably in the range of 55-95 mol %, and preferably 60-90 mol % per 100 mol % of the total quantity of the ingredients in the composition. The content of inert gas or gases is desirably in the range of 5-45 mol %, and preferably 10-40 mol %.

Furthermore, in the case where the chamber cleaning gas composition of the invention consists of FNO, O₂ and an inert gas or gases, the content of FNO is desirably in the range of 20-90 mol %, and preferably 30-80 mol % per 100 mol % of the total quantity of the ingredients in the composition. The content of the inert gas or gases is desirably in the range of 5-50 mol, and preferably 10-40 mol %.

Where the content of FNO, O₂ and inert gas(es) used in the chamber cleaning gas compositions falls within the above-mentioned ranges, it is possible to quickly remove the deposits on the surfaces of the interior of the CVD chambers.

In view of the chemical structure and physical and chemical properties of FNO, it is believed that the compound would have a short lifetime in the atmosphere and contribute less to global warming. Therefore, only a very slight adverse effect on environment would be caused if the chamber cleaning gas compositions were discharged into the atmosphere.

Further, even when FNO decomposes during use of the cleaning gas composition in the cleaning step, it would emit little or no noxious gases, such as CF₄, NF₃ and the like, that have high global warming potential and have an adverse effect on the environment.

Furthermore, since FNO has a low boiling point of -59.9°C, it is present in the gas phase when it is used under the conditions employed in the production of semiconductors and other electronic devices. Therefore, the gaseous FNO or gaseous mixtures containing it may be handled easily in the chamber cleaning operation.

FNO may be prepared, for example, by the below-formulated route at a high yield rate, but the preparation is not limited thereto:

F₂ + 2NO- 2FNO

The inert gases which may be used in the invention include, for example, N₂, He, Ne, Ar, Kr, Xe, and Rn.

As used herein, the expression "to clean a chamber" or any other synonymous expression is intended to mean removal of the films deposited on the surfaces of the inner walls, jigs, pipings, etc. exposed to the inside of chamber for manufacturing semiconductors or other electronic devices.

The above-mentioned gas compositions consisting of the specific fluorine-containing nitrogen compound, oxygen and other gases according to the invention may be used advantageously for cleaning CVD chambers, for example CVD equipment.

The target substances that are removed from the chamber by the fluorine-containing nitrogen compound according to the invention may be any deposit comprising the aforementioned silicon-containing compounds that have accumulated on the surfaces of the inner walls of the CVD chamber, jigs, pipings and other parts in the CVD apparatus during operation of the CVD process. Typical examples of the silicon-containing compounds include:
(1) compounds consisting essentially of silicon,
(2) compounds consisting essentially of silicon and at least one of oxygen, nitrogen, fluorine and carbon, and
(3) compounds comprising high melting point metal silicides.
Particular examples that may be mentioned include Si, SiO₂, Si₃N₄ and high melting point metal silicides, such as WSi, and the like.

The material from which the CVD chambers to be cleaned by the chamber cleaning gas compositions of the present invention are prepared is not critical, and may be, for example, stainless steel, aluminum or alloys thereof.

The chamber cleaning gas compositions of the present invention can quickly remove the deposits on the surfaces of the inner walls of the CVD chamber, jigs, pipings or other parts in the CVD apparatus, while having no or little adverse effects, such as corrosion, erosion and pitting, on these chamber materials.

Removal of the deposits comprising silicon-containing compounds and possibly traces of other substances present in the interior of the CVD chamber using the cleaning gas composition comprised of fluorine-containing nitrogen compound of the invention may be conducted in any known convenient manner. Various dry cleaning techniques, for example, plasma cleaning, remote plasma cleaning and microwave cleaning techniques may be employed. Thus, by means of the chamber cleaning gas compositions according to the invention, the deposited silicon-containing compounds may be efficiently removed.

### GAS COMPOSITIONS FOR ETCHING FILMS OF SILICON-CONTAINING COMPOUNDS:

The gas compositions for etching a thin film of silicon-containing compounds of the invention are listed in the claims. These etching gas compositions will be described below in more detail.

### FNO and mixtures thereof (etching gas compositions)

As mentioned hereinbefore, the gas composition for etching a film layer or layers of silicon-containing compounds according t the invention is characterized by the claims, which composition consists of O₂ and/or one or more inert gases in addition to the FNO. The contents of FNO, O₂ and inert gases in the etching gas composition are desirably in the same ranges as those for the ingredients of the chamber cleaning gas compositions that were mentioned hereinbefore. The etching gas compositions containing the ingredients in the specified proportions can rapidly etch a film layer or layers of silicon-containing compounds.

Even when the primary ingredient FNO employed in the etching gas compositions decomposes or degrades during or after use of the etching gas composition in the etching process, it would emit little or no noxious gases, such as CF₄, NF₃ and the like, that have high global warming potential and adverse environmental effects. In view of its chemical structure and chemical and physical properties, the FNO is believed to have a short lifetime in the atmosphere and contribute less to global warming. Therefore, only a very slight adverse effect on the environment would be caused, even if the etching gas compositions were discharged into the atmosphere.

Furthermore, because the etching gas compositions can highly selectively attack the films to be processed or etched, it is feasible for them to be employed as substitutes for the conventional etchant gases, such as CF₄, NF₃ etc.

As inert gases that may be incorporated into the etching gas compositions according to the invention, N₂, He, Ne, Ar, Kr, Xe and Rn may be mentioned.

### The materials to be etched:

The materials to be etched with the etching gas compositions of the invention include a thin film comprising silicon-containing compounds. Typical examples which may be mentioned are at least one of:
   (1) compounds consisting essentially of silicon,
   (2) compounds consisting essentially of silicon and at least one of oxygen, nitrogen, fluorine and carbon, and
   (3) compounds comprising high melting point metal silicides.

Particular examples that may be mentioned include Si film, SiO₂ film, Si₃N₄ film and films of high melting point metal silicides, such as WSi, and the like.

Etching of the films comprising silicon-containing compounds by means of the etching gas compositions comprising fluorine-containing nitrogen compound of the invention may be conducted in any known convenient manner. Various dry etching techniques, for example, plasma etching, reactive ion etching and microwave etching techniques may be employed. The conditions under which the present etching gas compositions are employed for etching may be similar to those suitable for application of the known etching techniques.

### Advantages achieved by the Invention:

The chamber cleaning gas compositions of the invention show little or no tendency towards generation, during or after use in a cleaning step, of an effluent gas stream containing noxious compounds, such as CF₄, NF₃ or the like, that could have an effect on global warming. Use of the chamber cleaning gas compositions of the present invention has only a limited effect on the environment. The chamber cleaning gas compositions of the invention may be handled with ease, can quickly remove the films adhering to the interior of the CVD chamber, and have improved cleaning qualities compared to those of conventional cleaning gases.

Furthermore, the present gas compositions for etching silicon-containing films show little or no tendency towards generation, during use in an etching process, of an effluent gas stream containing noxious compounds, such as CF₄, NF₃ or the like, that would have an effect on global warming. Use of the etching gas compositions of the present invention has only a limited effect on the environment. The etching gas compositions according to the invention can efficiently etch silicon-containing films while ensuring high dimensional accuracy of the product semiconductor patterns; they also demonstrate excellent etching capabilities compared to those of conventional etchant gases.

### EXAMPLE

The invention will be further illustrated in detail with reference to the following Examples which are not intended to be restrictive in any way to the scope of the invention.

### PREPARATION 1: SYNTHESIS OF FNO

A dried, 100 ml nickel reactor vessel was charged with 6.0 g (0.20 mol) of nitrogen monoxide followed with 1.34 liters of fluorine gas that had been diluted to 20 mol % (equal to 0.12 mol of F₂). The mixture was allowed to react at 30°C for one hour. The reaction products were subjected to isolation and purification to yield 8.8 g (0. 18 mol) of FNO. The resulting product was analyzed by gas chromatography and FT-IR. The product compound was identified to be FNO thereby. The yield was 90% on the basis of the starting nitrogen monoxide.

### EXAMPLES 1-6

### Chamber cleaning test:

Samples of FNO as produced in the above PREPARATION 1 were mixed with oxygen or argon (Ar) in various proportions as shown in TABLE 1.

A sample of silicon wafer having an SiO₂ film deposited over the surface thereof was placed in a CVD chamber and subjected to a cleaning test using one of the gas mixtures shown in TABLE 1, under the following cleaning conditions: a pressure of 110 Pa; an input Rf power of 290 W; and a total gas flow rate of 60 sccm. The cleaning procedure under these conditions was performed for a period of 2 minutes. The results of cleaning performance for each of the test cleaning gas compositions are shown in TABLE 1 below.

**TABLE 1**

| Examples | | 1 | 2 | 3 | 4 | 5 | 6 |
|---|---|---|---|---|---|---|---|
| Gas com position mol % | FNO | 30 | 40 | 50 | 60 | 80 | 90 |
| | O₂ | 70 | 60 | 50 | - | - | - |
| | Ar | - | - | - | 40 | 20 | 10 |
| Total mol % | | 100 | 100 | 100 | 100 | 100 | 100 |
| Cleaning rate Å/min. | | 540 | 620 | 470 | 420 | 620 | 550 |

### COMPARATIVE EXAMPLES 1-3

### Chamber cleaning test with conventional cleaning gas compositions:

The cleaning test procedure in the previous EXAMPLES was substantially repeated using some conventional cleaning gas compositions as shown in TABLE 2. The results are set forth in TABLE 2.

**TABLE 2**

| Comparative Examples | | 1 | 2 | 3 |
|---|---|---|---|---|
| Cleaning gas composition, mol % | C₂F₆ | 30 | 40 | 50 |
| | O₂ | 70 | 60 | 50 |
| Total mol % | | 100 | 100 | 100 |
| Cleaning rate Å/min. | | 670 | 690 | 680 |

From the cleaning test results of the above Examples, the feasibility of the present etching gas compositions is proved beyond doubt.

## Claims

1. Use of a gas composition for cleaning the interior of CVD chambers or etching a thin film comprising a silicon-containing compound or compounds, wherein said gas composition consists of FNO and O₂ and/or one or more inert gases.

2. Use as claimed in claim 1 wherein the gas composition consists essentially of FNO and O₂, the content of said FNO being in the range of 20 - 50 mol% of the total quantity of the gas ingredients in said composition.

3. Use as claimed in claim 2 wherein the gas composition is such that the content of said O₂ is in the range of 50 - 80 mol%.

4. Use as claimed in claim 1 wherein the gas composition consists essentially of FNO and one or more inert gases, the content of said FNO being in the range of 55 - 95 mol% of the total quantity of the gas ingredients in said composition.

5. Use as claimed in claim 4 wherein the gas composition is such that the content of said inert gas or gases is in the range of 5 - 45 mol% per 100 mol% of the total quantity of the gas ingredients in said composition.

6. Use as claimed in claim 1 wherein the gas composition consists of FNO, O₂ and one or more inert gases, the content of said FNO being in the range of 20 - 90 mol% of the total quantity of the gas ingredients in said composition.

7. Use as claimed in any preceding claim wherein the gas composition is such that said inert gas or gases are selected from the group consisting of N₂, He, Ne, Ar, Kr, Xe and Rn.

8. Use as claimed in any preceding claim wherein said cleaning comprises removing a deposit consisting of a silicon containing-compound or compounds in the interior of said chambers.

9. Use as claimed in any preceding claim wherein said silicon-containing compound or compounds are at least one selected from the group consisting of:
(1) compounds consisting essentially of silicon,
(2) compounds consisting essentially of silicon and at least one of oxygen, nitrogen, fluorine and carbon, and
(3) compounds comprising high melting point metal silicides.

10. A gas composition as defined in any of claims 1 to 7.

11. A gas composition as claimed in claim 10, wherein the gas composition consists of FNO and O₂, the content of said FNO being in the range of 20 - 50 mol% of the total quantity of the gas ingredients in said composition.

12. A gas composition as claimed in claim 11, wherein the gas composition is such that the content of said O₂ is in the range of 50 - 80 mol%.

13. A gas composition as claimed in claim 10, wherein the gas composition consists of FNO and one or more inert gases, the content of said FNO being in the range of 55 - 95 mol% of the total quantity of the gas ingredients in said composition.

14. A gas composition as claimed in claim 13, wherein the gas composition is such that the content of said inert gas or gases is in the range of 5 - 45 mol% per 100 mol% of the total quantity of the gas ingredients in said composition.

15. A gas composition as claimed in claim 10, wherein the gas composition consists of FNO, O₂ and one or more inert gases, the content of said FNO being in the range of 20 - 90 mol% of the total quantity of the gas ingredients in said composition.

## Patentansprüche

1. Verwendung einer Gaszusammensetzung zum Reinigen des Innenraums von CVD-Kammem oder zu Ätzen einer Dünnschicht, die eine Silicium-enthaltende Verbindung oder Verbindungen umfasst, worin die genannte Gaszusammensetzung aus FNO und O₂ und/oder einem oder mehreren Inertgasen besteht.

2. Verwendung nach Anspruch 1, worin die Gaszusammensetzung im Wesentlichen aus FNO und O₂ besteht, wobei der Gehalt an genanntem FNO im Bereich von 20-50 mol-% der Gesamtmenge der Gasbestandteile in der genannten Zusammensetzung liegt.

3. Verwendung nach Anspruch 2, worin die Gaszusammensetzung derart ist, dass der Gehalt an genanntem O₂ im Bereich von 50-80 mol-% liegt.

4. Verwendung nach Anspruch 1, worin die Gaszusammensetzung im Wesentlichen aus FNO und einem oder mehreren Inertgasen besteht, wobei der Gehalt an genanntem FNO im Bereich von 55-95 mol-% der Gesamtmenge der Gasbestandteile in der genannten Zusammensetzung liegt.

5. Verwendung nach Anspruch 4, worin die Gaszusammensetzung derart ist, dass der Gehalt an genanntem Inertgas oder genannten Inertgasen im Bereich von 5-45 mol-% pro 100 mol-% der Gesamtmenge der Gasbestandteile in der genannten Zusammensetzung liegt.

6. Verwendung nach Anspruch 1, worin die Gaszusammensetzung aus FNO, O₂ und einem oder mehreren Inertgasen besteht, wobei der Gehalt an genanntem FNO im Bereich von 20-90 mol-% der Gesamtmenge der Gasbestandteile in der genannten Zusammensetzung liegt.

7. Verwendung nach einem vorstehenden Anspruch, worin die Gaszusammensetzung derart ist, dass das genannte Inertgas oder die genannten Inertgase aus der Gruppe ausgewählt ist/sind, die aus N₂, He, Ne, Ar, Kr, Xe und Rn besteht.

8. Verwendung nach einem vorstehenden Anspruch, worin das genannte Reinigen das Entfernen einer Abscheidung, die aus einer Silicium-enthaltenden Verbindung oder Verbindungen im Innenraum der genannten Kammern umfasst.

9. Verwendung nach einem vorstehenden Anspruch, worin die genannte Silicium-enthaltende Verbindung oder die genannten Silicium-enthaltenden Verbindungen mindestens eines ist/sind, das aus der Gruppe ausgewählt ist, die aus Folgenden besteht:
(1) Verbindungen, die im Wesentlichen aus Silicium bestehen,
(2) Verbindungen, die im Wesentlichen aus Silicium und mindestens einem von Sauerstoff, Stickstoff, Fluor und Kohlenstoff bestehen, und
(3) Verbindungen, die hochschmelzende Metallsilicide umfassen.

10. Gaszusammensetzung, wie in einem der Ansprüche 1 bis 7 definiert.

11. Gaszusammensetzung nach Anspruch 10, worin die Gaszusammensetzung aus FNO und O₂ besteht, wobei der Gehalt an genanntem FNO im Bereich von 20-50 mol-% der Gesamtmenge der Gasbestandteile in der genannten Zusammensetzung liegt.

12. Gaszusammensetzung nach Anspruch 11, worin die Gaszusammensetzung derart ist, dass der Gehalt an genanntem O₂ im Bereich von 50-80 mol-% liegt.

13. Gaszusammensetzung nach Anspruch 10, worin die Gaszusammensetzung aus FNO und einem oder mehreren Inertgasen besteht, wobei der Gehalt an genanntem FNO im Bereich von 55-95 mol-% der Gesamtmenge der Gasbestandteile in der genannten Zusammensetzung liegt.

14. Gaszusammensetzung nach Anspruch 13, worin die Gaszusammensetzung derart ist, dass der Gehalt an genanntem Inertgas oder genannten Inertgasen im Bereich von 5-45 mol-% pro 100 mol-% der Gesamtmenge der Gasbestandteile in der genannten Zusammensetzung liegt.

15. Gaszusammensetzung nach Anspruch 10, worin die Gaszusammensetzung aus FNO, O₂ und einem oder mehreren Inertgasen besteht, wobei der Gehalt an genanntem FNO im Bereich von 20-90 mol-% der Gesamtmenge der Gasbestandteile in der genannten Zusammensetzung liegt.

## Revendications

1. Utilisation d'une composition gazeuse pour nettoyer l'intérieur d'enceintes de CVD ou graver un film mince, comprenant un composé ou des composés contenant du silicium, où ladite composition gazeuse est constitué de FNO et O₂ et/ou d'un ou plusieurs gaz inertes.

2. Utilisation selon la revendication 1, dans laquelle la composition gazeuse est essentiellement constituée de FNO et O₂, la teneur dudit FNO étant dans la plage de 20-50 % en moles par rapport à la quantité totale des ingrédients gazeux dans ladite composition.

3. Utilisation selon la revendication 2, dans laquelle la composition gazeuse est telle que la teneur dudit O₂ est dans la plage de 50-80 % en moles.

4. Utilisation selon la revendication 1, dans laquelle la composition gazeuse est essentiellement constituée de FNO et d'un ou plusieurs gaz inertes, la teneur dudit FN étant dans la plage de 55-95 % en moles par rapport à la quantité totale des ingrédients gazeux dans ladite composition.

5. Utilisation selon la revendication 4, dans laquelle la composition gazeuse est telle que la teneur dudit ou desdits gaz inertes est dans la plage de 5-45 % en moles pour 100 % en moles de quantité totale des ingrédients gazeux dans ladite composition.

6. Utilisation selon la revendication 1, dans laquelle la composition gazeuse est constituée de FNO, O₂ et d'un ou plusieurs gaz inertes, la teneur dudit FNO étant dans la plage de 20-90 % en moles par rapport à la quantité totale des ingrédients gazeux dans ladite composition.

7. Utilisation selon l'une quelconque des revendications précédentes, dans laquelle la composition gazeuse est telle que ledit ou lesdits gaz inertes sont choisis dans le groupe constitué de N₂, He, Ne, Ar, Kr, Xe et Rn.

8. Utilisation selon l'une quelconque des revendications précédentes, dans laquelle ledit nettoyage comprend l'élimination d'un dépôt constitué d'un composé ou de composés contenant du silicium à l'intérieur desdites enceintes.

9. Utilisation selon l'une quelconque des revendications précédentes, dans laquelle ledit composé ou lesdits composés contenant du silicium sont au moins un composé choisi dans le groupe constitué de :
(1) les composés essentiellement constitués de silicium,
(2) les composés essentiellement constitués de silicium et d'au moins un élément parmi l'oxygène, l'azote, le fluor et le carbone, et
(3) les composés comprenant des siliciures de métal à haut point de fusion.

10. Composition gazeuse telle que définie dans l'une quelconque des revendications 1 à 7.

11. Composition gazeuse selon la revendication 10, dans laquelle la composition gazeuse est constituée de FNO et O₂, la teneur dudit FNO étant dans la plage de 20-50 % en moles par rapport à la quantité totale des ingrédients gazeux dans ladite composition.

12. Composition gazeuse selon la revendication 11, dans laquelle la composition gazeuse est telle que la teneur dudit O₂ est dans la plage de 50-80 % en moles.

13. Composition gazeuse selon la revendication 10, dans laquelle la composition gazeuse est constituée de FNO, et d'un ou plusieurs gaz inertes, la teneur dudit FNO étant dans la plage de 55-95 % en moles par rapport à la quantité totale des ingrédients gazeux dans ladite composition.

14. Composition gazeuse selon la revendication 13, dans laquelle la composition gazeuse est telle que la teneur dudit ou desdits gaz inertes est dans la plage de 5-45 % en moles pour 100 % en moles de quantité totale des ingrédients gazeux dans ladite composition.

15. Composition gazeuse la revendication 10, dans laquelle la composition gazeuse est constituée de FNO, O₂ et d'un ou plusieurs gaz inertes, la teneur FNO étant dans la plage de 20-90% en moles par rapport à la quantité totale des ingrédients gazeux dans ladite composition.
